Europäisches Patentamt

European Patent Office

Office européen des brevets

(11) Publication number: **0 319 214**
**A1**

## (12) EUROPEAN PATENT APPLICATION

(21) Application number: 88311214.6

(22) Date of filing: 25.11.88

(51) Int. Cl.⁴: **H01L 21/285**

(30) Priority: 04.12.87 US 128859

(43) Date of publication of application:
07.06.89 Bulletin 89/23

(84) Designated Contracting States:
**DE ES FR GB IT NL**

(71) Applicant: **AMERICAN TELEPHONE AND TELEGRAPH COMPANY**
**550 Madison Avenue**
**New York, NY 10022(US)**

(72) Inventor: **Desko, John Charles, Jr.**
**5230 Andrea Drive**
**Wescosville Pennsylvania 18106(US)**
Inventor: **Rana, Virendra Vir Singh**
**1524 Red Maple Lane**
**Allentown Pennsylvania 18104(US)**

(74) Representative: **Johnston, Kenneth Graham et al**
**AT&T (UK) LTD. AT&T Intellectual Property Division 5 Mornington Road**
**Woodford Green Essex, IG8 OTU(GB)**

(54) Method for making semiconductor integrated circuits using selective tungsten deposition.

(57) Windows in dielectrics overlying a electrically conducting silicon substrate are filled with tungsten using a two-step deposition process using first the reaction of $WF_6$ with the silicon and then with $H_2$ gas.

EP 0 319 214 A1

## Method for Making Semiconductor Integrated Circuits Using Selective Tungsten Deposition

### Technical Field

This invention relates to semiconductor integrated circuits having metallizations using tungsten.

### Background of the Invention

The most commonly used metal, aluminum, in semiconductor integrated circuits suffers drawbacks, for example, poor step coverage and reentrant angles, which become more severe as device geometries, especially windows which must be filled, decrease in size. These drawbacks are especially troublesome as device geometries use submicron technologies. Consequently, alternatives to aluminum which lack these drawbacks have been sought for use in submicron technologies. One such alternative is LPCVD tungsten which is an attractive candidate because it can be deposited with nearly perfect step coverage. A tungsten plug can be formed in windows such that if Al is subsequently deposited and patterned the aspect ratio over which Al has to deposit is greatly reduced. Additionally, the tungsten plug can serve as a diffusion barrier to prevent aluminum spiking. It also acts as an etch stop if headless metal runners are to be fabricated by aluminum patterning.

Tungsten deposition may be either selective or blanket. In the latter deposition method, tungsten is deposited on the entire surface, including the windows, and is subsequently etched back to strip all metal from the dielectric surfaces and, ideally, leave a planar surface formed by the tungsten and the surrounding dielectric.

With the selective deposition method, tungsten is deposited only in the vias or windows. While high selectivity can be obtained, that is, very little tungsten is deposited on the dielectric surface, it has been found that typical tungsten deposition processes produce several adverse effects. These effects may be better understood by considering the chemistry of the deposition processes. The most common deposition process uses the reactions of $WF_6$ with the gas $H_2$ to form a metal layer of tungsten and HF which is gaseous. However, when depositing tungsten on Si substrates, even in the presence of $H_2$, $WF_6$ is reduced by Si to form tungsten and the volatile species $SiF_4$. The strong interaction of reactants such as $WF_6$ and by-products such as HF with silicon leads to at least three adverse effects: (1) silicon consumption, (2) encroachment, and (3) worm holes. The first effect is easily explained. Silicon is consumed during the deposition process. In the reaction of $WF_6$ with silicon, approximately 2 volume units of silicon are consumed for each volume unit of tungsten deposited. The second effect results from the fact that not only is tungsten deposited on the bottom of the window but also underneath the dielectric at the bottom of the hole. The mechanism for this effect is not understood but is believed by many skilled in the art to be related to the fact that the dielectric silicon interface is under stress which helps promote tungsten growth near the interface. Experimental evidence is, however, lacking. The growth of tungsten near the silicon-dielectric interface may be so extensive that tungsten growth results in electrical shorts between source and drain regions. The third effect is more complex and results in tungsten particles penetrating a significant distance into the silicon. It is believed by many skilled in the art that a possible mechanism for this effect is that the tungsten particle acts as a catalyst for decomposition of HF into H and F. Again, experimental evidence is lacking. The penetration of the tungsten particle into silicon results in the formation of a hole in the silicon which is empty except for a tungsten particle at the end of the hole. The term "worm hole" is descriptive of the resulting defect.

It is believed that some of these adverse effects may be avoided or mitigated by the use of a multi-step tungsten deposition process in which $WF_6$ is first used to deposit a thin tungsten layer by reacting with silicon. $WF_6$ is then used to react with $H_2$ to form additional tungsten. The thin metal layer at the bottom of the window and acts as a barrier layer reducing the reaction of $WF_6$ with silicon thus reducing further silicon consumption and may also inhibit the formation of worm holes during the $H_2$ reduction of $WF_6$.

However, this approach, although conceptually simple, has not been completely successful for several reasons. It has generally been believed that the $WF_6$ reaction with the silicon is self-limiting, that is, it proceeds until a layer of tungsten has been formed that is sufficiently thick to preclude additional reactions of $WF_6$ with the silicon from occurring at a reasonable rate. The maximum thickness of the layer thus grown is not known with certainty as the maximum thickness attainable appears to vary with several experimental conditions such as temperature, substrate cleanliness, etc. Most of this work used hot wall reactors.

For the tungsten plug to be useful in device applications, it should form a low resistance contact with silicon while causing no increase in junction leakage current. Both electrical properties are very resistive to the deposition conditions. Using inappropriate deposition conditions, either high contact resistance or high leakage currents were obtained. Workers in the art have not reported deposition conditions that can be used to obtain both low contact resistance and low leakage current.

Some attention has recently been given to two-step processes using cold wall reactors. For example, R. Chow et al., Tungsten and Other Refractory Metals for VLSI Applications-II, Proceedings of the 1986 Tungsten Workshop, pp. 137-146, reported a multi-step process beginning with using $WF_6$ without $H_2$ to deposit a thin barrier film of tungsten. Foster et al., same conference, pp. 147-155, report selective tungsten deposition in a cold wall system. Minimal silicon consumption was reported. It was also reported that surface contaminants, e.g., oxide, resist residue, might inhibit tungsten nucleation and lead to excessive silicon consumption. It was also suggested that damage caused by ion implantation might be important. Believing that the tungsten deposition process using the reduction of $WF_6$ by silicon was self-limiting, prior art workers typically deposited without a great amount of consideration given to the deposition conditons.

Not only must the three problems discussed previously be avoided but both contact resistance and leakage currents must be at least reduced to acceptable levels if not minimized. The tungsten deposition conditions used during the Si reduction of $WF_6$ have a dominant effect on the contact resistance as well as the leakage current obtained after forming the thick plug. However, these are conflicting requirements as contact resistance is low when the first step is performed at high temperatures and $WF_6$ partial pressures as well as a long $WF_6$ flow time while leakage currents are low when the silicon reduction is carried out at low temperatures and $WF_6$ partial pressures and a short $WF_6$ flow time.

## Summary of the Invention

In a process of semiconductor integrated circuit manufacture, we have found that tungsten plugs may be deposited in a patterned dielectric by a two-step tungsten deposition process that deposits a layer of tungsten using the reaction between $WF_6$ and silicon with the deposition at a temperature sufficiently high so that the tungsten forms an intimate contact with the silicon and for a time and with a flow rate sufficient to deposit a tungsten layer sufficient to cover the exposed material. This is followed by depositing further tungsten using $WF_6$ and $H_2$. It has been found that process parameters can be selected so that both low contact resistance and low leakage currents are obtained. The first process does not lead to a self-limiting layer under the deposition parameters used and it is noted that no worm holes were seen. The contact resistance is also low for electrical contacts to p+-type regions formed by using B implants Additionally, junction leakage is low because of minimal silicon consumption and encroachment and no worm holes.

## Detailed Description

Devices studied had silicon substrates and disposed thereon a patterned dielectric containing windows exposing both p+ and n+ regions. The n+ regions were formed by implanting arsenic at 80 KeV to a concentration of $5 \times 10^{15}/cm^2$ and phosphorus at 35 KeV to a concentration of $3 \times 10^{14}/cm^2$ into a p-type tub. The p+ regions were formed by implanting boron at 30 KeV and a concentration of $2 \times 10^{15}/cm^2$ into an n-type tub. The junctions were then annealed at 850°C for 60 minutes to yield junctions depths of 0.3 and 0.5 microns for the n+ and p+ junctions, respectively. Contacts windows 1.25 microns in diameter were then opened by reactive sputter etching through a 0.5 micron thick dielectric layer to openings to the implanted regions.

A cold wall deposition system made by Genus, Inc. was then used to make plugs using a multi-step selective deposition process. The first step used $WF_6$ reacting with Si to form tungsten and $SiF_4$. Typical deposition conditions are a temperature of 500°C, a chamber pressure of 120 mtorr, $WF_6$ and argon flow rates of 20 and 1000 sccm, respectively, and a time of 1 minute. The temperatures are current temperatures. These conditions produce 20 to 40 nanometer (200 to 400 Angstrom) thick layers on n+ and p+ silicon. It has been found that under these deposition conditions that the thickness of the deposited tungsten is not self-limiting. Performing this reaction at a high $WF_6$ flow rate or a high partial pressure for a long time produce a large junction leakage due to excessive encroachment.

The temperature should be sufficiently high so that the tungsten forms an intimate contact with the silicon, i.e., there are minimal contaminants on the silicon surface. A temperature of at least 400°C is desirable. Excessive temperatures should be avoided as silicon consumption may be too high. Temperatures greater than 600°C are desirably avoided. The time and flow rate are typically low and are selected so that a tungsten layer adequate to thoroughly cover the silicon is grown. A thickness of 20 to 40 nanometer (200 to 400 Angstrom) is generally sufficient. Times less than 5 minutes, and as short as 1 minute, are adequate.

This was followed by deposition of tungsten using the reaction between $WF_6$ and $H_2$. Typical deposition conditions are a temperature of 600°C, a chamber pressure of 600 mtorr and $WF_6$ and $H_2$ flow rates of 100 and 6000 sccm, respectively. The deposition is performed for a time sufficient to completely fill the window.

After tungsten deposition was completed, aluminum was deposited and patterned. The contacts were then tested for both resistance and junction leakage. Well known techniques were used for these measurements. Contacts obtained had both low leakage and contact resistance.

Other embodiments are contemplated. For example, although described in terms of silicon, the tungsten may be deposited on other materials.

## Claims

1. A method of semiconductor integrated circuit fabrication comprising the steps of
depositing and patterning a dielectric on a substrate, said pattern forming openings which expose electrically conducting portions of said silicon substrate, and filling said openings with tungsten, said filling comprises a first step depositing tungsten using the reaction of $WF_6$ with Si and a second step depositing tungsten using the reaction of $WF_6$ with $H_2$ CHARACTERIZED IN THAT said first depositing step is at a temperature sufficient for said tungsten to form an intimate contact with said substrate and for a time and with a flow rate sufficient to grow a tungsten layer that thoroughly covers the substrate.

2. A method as recited in claim 1 in which said substrate comprises silicon.

3. A method as recited in claim 2 in which said temperature is at least 400°C.

4. A method as recited in claim 3 in which said temperature is less than 600°C.

5. A method as recited in claim 4 in which said tungsten layer has a thickness of at least 20 nanometers (200 Angstroms).

## DOCUMENTS CONSIDERED TO BE RELEVANT

| Category | Citation of document with indication, where appropriate, of relevant passages | Relevant to claim | CLASSIFICATION OF THE APPLICATION (Int. Cl. 4) |
|---|---|---|---|
| D,X | E.K. BROADBENT et al. "TUNGSTEN AND OTHER REFRACTORY ME FOR VLSI APPLICATIONS II", Proceedings of the 1986 Workshop, Palo Alto, 12th-14th November 1986, Materials Research Society, Pittsburg, US; pages 137-146, R. CHOW et al.: "Selective tungsten deposition in a batch cold wall CVD system" * Whole article * | 1 | H 01 L 21/285 |
| D,A | IDEM | 2-5 | |
| X | DE-A-3 625 860 (TOSHIBA) * Figure 5A; column 6, lines 1-30 * | 1 | |
| A | | 2-5 | |

TECHNICAL FIELDS SEARCHED (Int. Cl.4)

H 01 L

The present search report has been drawn up for all claims

| Place of search | Date of completion of the search | Examiner |
|---|---|---|
| THE HAGUE | 13-03-1989 | PHEASANT N.J. |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

& : member of the same patent family, corresponding
    document

EPO FORM 1503 03.82 (P0401)